## Europäisches Patentamt
## European Patent Office
## Office européen des brevets

(11) Publication number: **0 103 023**
**B1**

## EUROPEAN PATENT SPECIFICATION

(45) Date of publication of patent specification: **05.10.88**

(21) Application number: **83900653.3**

(22) Date of filing: **10.02.83**

(86) International application number: **PCT/JP83/00040**

(87) International publication number: **WO 83/03031 01.09.83 Gazette 83/20**

(51) Int. Cl.⁴: **H 01 L 27/14, H 04 N 5/30**

(54) SOLID-STATE IMAGE PICKUP DEVICE.

(30) Priority: **19.02.82 JP 25731/82**

(43) Date of publication of application:
**21.03.84 Bulletin 84/12**

(45) Publication of the grant of the patent:
**05.10.88 Bulletin 88/40**

(84) Designated Contracting States:
**DE FR GB NL**

(56) References cited:
**GB-A-2 007 937**
**GB-A-2 065 974**
**JP-A-55 031 333**

(73) Proprietor: **SONY CORPORATION**
**7-35 Kitashinagawa 6-Chome Shinagawa-ku**
**Tokyo 141 (JP)**

(72) Inventor: **TAKESHITA, Kaneyoshi Atsugi Plant**
**Sony Corporation 14-1, Asahi-cho 4-chome**
**Atsugi-shi Kanagawa-ken 243 (JP)**

(74) Representative: **Thomas, Christopher Hugo**
**et al**
**D Young & Co 10 Staple Inn**
**London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 103 023 B1

# Description

This invention relates to solid-state image pick-up apparatus comprising a solid state image pick-up device.

Solid state image pick-up devices comprising a charge transfer device such as a charge coupled device (CCD) are classified broadly into the frame transfer type and the interline transfer type.

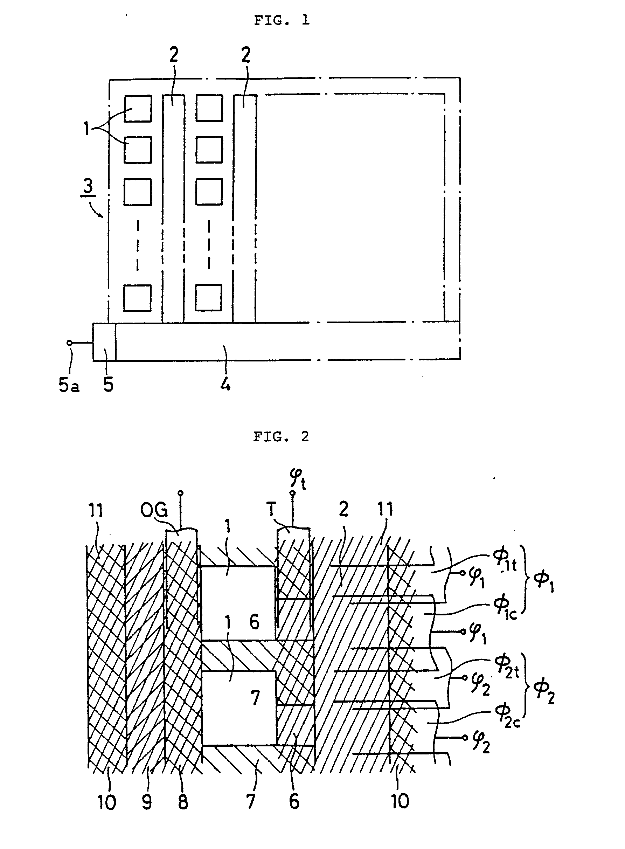

An example of a solid state image pick-up device of the interline transfer type using a CCD is shown in Figure 1, and comprises a photosensing and vertical transfer portion 3 which includes a plurality of photodetectors 1 arranged in horizontal and vertical rows, and vertical transfer portions 2 each formed with a group of CCDs along each of the vertical rows of photodetectors 1, a horizontal transfer portion 4 coupled with the photo-sensing and vertical transfer portion 3, and an output portion 5 coupled with the horizontal transfer portion 4 and provided with a signal output terminal 5a, all formed on a common semiconductor substrate.

In this apparatus, predetermined vertical and horizontal transfer driving signals are applied to the vertical and horizontal transfer portions 2 and 4 respectively, so that vertical and horizontal charge transfers are performed. Signal charge obtained in the photodetectors 1 in response to the light received thereby during, for example one frame period, is read out to the vertical transfer portions 2 and then transferred vertically towards the horizontal transfer portion 4 during each horizontal blanking period, so that the signal charge produced in each horizontal row of the photodetectors 1 is transferred in turn to the horizontal transfer portion 4. This signal charge is further transferred horizonally to the output portion 5 by the charge transfer operation of the horizontal transfer portion 4 during each horizontal video period, and as a result of this an image pick-up signal output is obtained at the terminal 5a.

The photo-sensing and vertical transfer portion 3 contains transfer gate areas 6 between row of photodetectors 1 and the corresponding one of the vertical transfer portions 2, and a channel stop area 7 and an overflow control gate portion 8 around each of the photodetectors 1, as shown in Figure 2. An overflow drain 9 is provided contiguous to each of the overflow control gate portions 8, and each of the overflow drains 9 and the corresponding one of the vertical transfer portions 2 are separated by a channel stop area 10. These various areas and portions are covered by an insulating layer on which vertical transfer electrodes $\phi1$ and $\phi2$ each elongated in the horizontal direction are provided alternately in the vertical direction at the areas corresponding to the vertical transfer portions 2. Each vertical transfer electrode $\phi1$ comprises a charge storage electrode $\phi1c$ and a charge transfer electrode potential barrier electrode) $\phi1t$, and each vertical transfer electrode $\phi2$ comprises a charge storage electrode $\phi2c$ and a charge transfer electrode $\phi2t$.

In the vertical transfer portions 2, storage regions are formed under the charge storage electrodes $\phi1c$ and $\phi2c$, and transfer regions (potential barrier regions) are formed under the charge transfer electrodes $\phi1t$ and $\phi2t$, and each transfer region is subjected to ion implantation or provided thereon with a thick insulating layer so as to have a potential shallower (lower) than that of the storage region adjacent thereto, and to form a potential barrier. A transfer gate electrode T extending in the vertical direction is provided on each group of transfer gate areas 6 aligned in the vertical direction, and an overflow control gate electrode OG also extending in the vertical directions is provided on each overflow control gate portion 8. A light shielding layer 11 is also provided on these various areas and portions except the areas of the photodetectors 1 to form a light shielded portion.

In the photo-sensing and vertical transfer portion 3, a predetermined gating signal $\varphi t$ is supplied to the transfer gate electrodes T so that a transfer gate voltage is applied selectively to the transfer gate areas 6, and a predetermined bias voltage is supplied through the overflow control gate electrodes OG to the overflow control gate portions 8. Then the vertical transfer electrodes $\phi1$ and $\phi2$ are supplied with two-phase driving signals $\varphi1$ and $\varphi2$, respectively, and the voltages of the driving signals $\varphi1$ and $\varphi2$ are applied to the vertical transfer portions 2 positioned under the vertical transfer electrodes $\phi1$ and $\phi2$. With such driving signals $\varphi1$ and $\varphi2$, signal charge stored in the photodetectors 1 forming each vertical alignment thereof is read out through the transfer gate areas 6 to the vertical transfer portions 2 at every field period, for example, and this signal charge is transferred vertically to the horizontal transfer portion 4 during each period corresponding to the horizontal blanking period.

When this solid state image pick-up device is in operation, the portion where the light from an object is received is limited to the photodetectors on which no light shielding layer is provided and therefore the light receiving aperture ratio, that is, the ratio of the light receiving area to the whole area of the photo-sensing and vertical transfer portion 3 is quite low. Consequently, the photosensitivity of the device is low, and especially in the case of operation for producing an image pick-up signal output representing a still image, in which the light is received for a short period during which a shutter mechanism for the photosensing and vertical transfer portion 3 is open, and the image pick-up output signal is obtained in response to signal charge stored in the photodioses 1 during such a short period, an image pick-up signal output with sufficient dynamic range and a good signal-to-noise ratio cannot be obtained.

According to the present invention there is provided a solid state image pick-up apparatus comprising a solid state image pick-up device of the interline transfer type having photodetectors for producing signal charge in response to the light received thereby and storing the signal charge produced therein, transfer portions for transferring the signal charge read out from the photodetectors, and transfer gate areas provided between the photodetectors, and transfer portions for reading out the signal charge from the photodetectors to the corresponding transfer portions, and being formed such that the photodetectors and the transfer portions are not covered with a light shielding layer, and a shutter mechanism associated with the solid state image pick-up device, wherein the shutter mechanism is made open and the relationship of $Pr \leq Pt < Ps$, where Ps, Pt and Pr are the potentials of the photodetector, the corresponding transfer gate area and the corresponding transfer portion, respectively, is maintained during a light receiving period, the shutter mechanism is shut and the relationship of $Ps \leq Pt < Pr$ is maintained during a reading out period, and the shutter mechanism is shut and the relationship of $Pt < Ps$ and $Pt < Pr$ is maintained during a charge transfer period, thereby to produce an image pick-up signal output in response to the signal charge transferred by the transfer portions.

The invention will now be described by way of example with reference to the accompanying drawings, throughout which like parts are referred by by like references, and in which:

Figure 1 is a schematic plan view showing a solid state image pick-up device of the interline transfer type;

Figure 2 is a plan view shown an enlarged portion of a photosensing and vertical transfer portion in a previously proposed solid state image pick-up device of the interline transfer type;

Figure 3 is a plan view showing an enlarged portion of a photosensing and vertical transfer portion in a solid state image pick-up device of the interline transfer type employed in one embodiment of the present invention; and

Figures 4A, 4B and 4C are waveform diagrams used for explaining the operation of the embodiment.

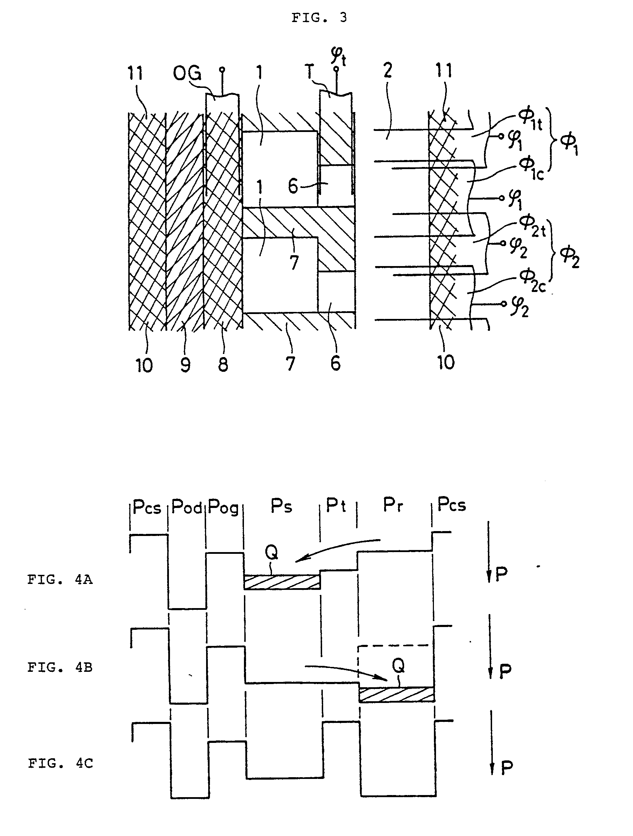

The solid state image pick-up device of the interline transfer type having a portion thereof as shown in Figure 3 comprises a CCD and has the ame configuration as that of Figure 1. In Figure 3, photodetectors 1, vertical transfer portions 2, transfer gate areas 6, channel stop areas 7, overflow control gate portions 8, overflow drains 9 and channel stop areas 10 are shown as in Figure 2, and vertical transfer electrodes $\phi 1$ each comprising a charge storage electrode $\phi 1c$ and a charge transfer electrode $\phi 1t$, vertical transfer electrodes $\phi 2$ each comprising a charge storage electrode $\phi 2c$ and a charge transfer electrode $\phi 2t$, transfer gate electrodes T and overflow control gate electrodes OG are provided as in Figure 2.

The photo-sensing and vertical transfer portion shown in Figure 3 has a light shielded portion different from that in Figure 2. In Figure 3, a light shielding layer 11 is provided only on the overflow control gate portion 8, the overflow drain 9 and the channel stop area 10 to form the light shielded portion. Accordingly, the vertical transfer portion 2, the transfer gate area 6 and the channel stop area 7 form respective light receiving portions, not covered by the light shielding layer 11, in addition to the photodetector 1.

The solid state image pick-up apparatus embodying the present invention has such a solid state pick-up device and a shutter mechanism for limiting the light entering the photo-sensing and vertical transfer portion so as to produce an image pick-up signal output representing a still image.

When producing the image pick-up signal output, the potential of each portion or area in the photo-sensing and vertical transfer portion is controlled. During a light receiving period when the shutter mechanism is open, and the photodetectors 1 store signal charge therein in response to the received light, the relationship between the potentials of portions and areas in the photo-sensing and vertical transfer portion is as shown in Figure 4A, where Ps stands for the potential of the photodetector 1, Pr stands for the potential of the vertical transfer portion 2, Pt stands for the potential of the transfer gate area 6, Pog stands for the potential of the overflow control gate portion 8, Pod stands for the potential of the overflow drain 9, and Pcs stands for the potential of the channel stop area 10. During a reading out period in which the signal charge stored in the photodetectors 1 is read out through the transfer gate areas 6 to the vertical transfer portions 2, the shutter mechanism is shut and the relationship between the portions and areas is as shown in Figure 4B, and during a charge transfer period in which the signal charge transferred to the vertical transfer portions 2 is further transferred to the horizontal transfer portion 4, the shutter mechanism is shut and the relationship is as shown in Figure 4C. In Figures 4a, 4b and 4C, the potential P becomes high (deep) downward. Broken lines in connection with the potential Pr in Figure 4B shown the potential of the vertical transfer portions 2 corresponding to the photodetectors 1 from which the signal charge is not read out during a certain field period in the field interlace reading operation, in which signal charge stored in one of each of two photodetectors 1 adjacent vertically to each other, and signal charge stored in the other of the two photodetectors 1 are read out alternately every field period. In the charge transfer period, the potential Pr of the vertical transfer portion 2 varies under the vertical transfer electrodes $\phi 1$ and $\phi 2$ in response to the driving signal supplied thereto and the potential Pr shown in Figure 4C repesents the deeper potential level.

As apparent from Figures 4A, 4B and 4C, each of the potentials Ps, Pog, Pod and Pcs of the phototdetector 1, the overflow control gate portion 8, the overflow drain 9 and the channel stop area, respectively, is maintained constant throughout the light receiving period, the reading out period and the charge transfer period, and the relationhip $Pcs<Pog<Ps<Pod$ is maintained. Accordingly, when charge which exceeds the potential barrier by the potential Pog is produced in the photodetectors 1, such excessive charge overflows into the overflow drain 9 to be drained therethrough.

On the other hand, both the potential Pr of the vertical transfer portion 2 and the potential Pt of the transfer gate area 6 vary in response to the voltages of the driving signals $\varphi 1$ and $\varphi 2$ supplied to the vertical transfer electrodes $\varphi 1$ and $\varphi 2$ and the gating voltage resulting from the gating signal $\varphi t$ supplied to the transfer gate electrode T, respectively.

First, during the light receiving period, the relationship $Pr<Pt<Ps$ is maintained, as shown in Figure 4A. During this period, the photodetectors 1, the vertical transfer portions 2 and the transfer gate areas 6, each of which is not covered with the light shielding layer 11, receive the light coming through the open shutter mechanism and produce charge in response to the received light. Since the relationship $Pr<Pt<Ps$ is maintained, the charge produced in the photodetectors 1, the vertical transfer portions 2 and the transfer gate areas 6 are collected to the photdetectors 1 having the highest potential and stored therein as signal charge Q. In this case, the relationship $Pr=Pt<Ps$ can be taken in place of the relationship $Pr<Pt<Ps$. As described above, the charge produced in the vertical transfer portions 2 and the transfer gate areas 6 becomes signal charge in addition to the charge produced in the photodetectors 1, and the vertical transfer portions 2 in particular act as a light receiving portion having a relatively large area, so that the signal charge produced in response to the light entering the photo-sensing and vertical transfer portion is substantially increased. That is, the light receiving aperture ratio is substantially increased and therefore the photo-sensitivity is improved.

Then, during the reading out period, the relationship $Ps=Pt<Pr$ is maintained, as shown in Figure 4B, consequently, the signal charge stored in the photodetectors 1 is read out through the transfer gate area 6 to the vertical transfer portions 2. In this case, the relationship $Ps<Pt<Pr$ can be taken in place of the relationship $Ps=Pt<Pr$. During this period, since the shutter mechanism is shut, the light cannot reach any of the photodetectors 1, the vertical transfer portions 2 and the transfer gate areas 6. In the case of the field interlace reading operation, the potential Pr of the vertical transfer portion corresponding to the photodetector 1 from which the signal charge is not read out is lower than the potential Pt of the transfer gate area 6, as shown by the broken lines in Figure 4B.

Moreover, during the charge transfer period, the relationship $Pt<Ps$, $Pt<Pr$ is maintained, and the potential Pr varies between a high level and a low level in response to vertical transfer pulses in the driving signals $\varphi 1$ and $\varphi 2$, so that the signal charge Q is transferred to the horizontal transfer portion 4 from the vertical transfer portions 2 during each period corresponding to the horizontal blanking period.

During this period also, the shutter mechanism is shut and therefore light cannot reach any of the photodetectors 1, the vertical transfer portions 2 and the transfer gate areas 6.

The signal charge Q transferred to the horizontal blanking period transfer portion 4 during each period corresponding to the horizontal blanking period is further transferred to the output portion 5 from the horizontal transfer portion 4 during each period corresponding to the horizontal video period, and as a result of this, an image pick-up signal output representing a still image is obtained at the terminal 5a in the form of successive segments each corresponding to one field period.

Concerning the vertical transfer electrodes $\varphi 1$ and $\varphi 2$ and the transfer gate electrode T provided in the photo-sensing and vertical transfer portion shown in Figure 3, it is convenient to form the transfer gate electrode T first and then to form the vertical transfer electrodes $\varphi 1$ and $\varphi 2$ on the transfer gate electrode T with an insulating layer therebetween.

Although, in this embodiment, the vertical transfer electrodes $\varphi 1$ and $\varphi 2$ cause the vertical charge transfer to be performed in the two-phase transfer mode with two-phase driving signals, it is also possible to provide different vertical transfer electrodes which cause the vertical charge transfer to be performed in the three or four phase transfer mode with three or four-phase driving signals. Moreover, in place of the overflow drain 9 formed two-dimensionally in the above embodiment, other overflow drains formed in a different manner can be provided.

Embodiments of the invention can produce an image pick-up signal output representing a high-shuttering speed still image with enlarged dynamic range and an improved signal-to-noise ratio with low smear and bloom, and are therefore suitable for high-grade, miniature, lightweight still television cameras.

**Claims**

1. A solid state image pick-up apparatus comprising a solod state image pick-up device of the interline transfer type having photodetectors (1) for producing signal charge produced therein, transfer portions (2) for transferring the signal charge read out from the photodetectors (1), and transfer gate areas (6) provided between the photodetectors (1) and the transfer portions (2) for reading out the signal charge from the photodetectors (1) to the corresponding transfer portions (2), and being formed such that the photodetectors (1) and the transfer portions (2) are not covered with a light shielding layer (11), and a shutter mechanism associated with the solid state image pick-up device, wherein the shutter mechanism is made open and the relationship of $Pr \leqslant Pt<Ps$, where Ps, Pt and Pr are the potentials of the photodetector (1), the corresponding transfer portion (2), respectively, is maintained during a light receiving period, the shutter mechansim is shut and the relationship of $Ps \leq Pt < Pr$ is maintained during a reading out period, and the shutter mechanism is shut and the relationship of $Pt < Ps$ and $Pt < Pr$ is maintained during a charge transfer period, thereby to produce an image pick-up signal output in response to the signal charge transferred by the transfer portions (2).

2. Apparatus according to claim 1 wherein said device further has a channel stop area (7) between each two adjacent photodetectors (1) and said channel stop areas (7) and said transfer gate areas (6) are not covered with the light shielding layer (11).

## Patentansprüche

1. Halbleiterbildaufnahmegerät mit einer Halbleiterbildaufnahmeeinrichtung vom Zweishenzeilenübertagungstyp

mit Photodetektoren (1) zur Erzeugung von Signalladung in Abhängigkeit von dem von ihnen Aufgenommenen Licht und zur Speicherung der ihn ihnen erzeugten Signalladung,

mit Übertragungsbereichen (2) zum Übertragen der aus den Photodetektoren (1) ausgelesenen Signalladung,

und mit zwischen den Photodetektoren (1) und den Übertragungsbereichen (2) angeordneten Übertragungs-Gate-Zonen (6) zum Auslesen der Signalladung aus den Photodetektoren (1) an die zugeordneten Übertragungsbereiche,

wobei die Übertragungsbereiche (2) nicht von einer Lichtabschirmungsschicht (11) bedeckt sind,

ferner mit einem der Halbleiterbildaufnahmeeinrichtung zugeordneten Verschlußmechanismus,

wobei zur Erzeugung eines Bildaufnahme-Ausgangssignals in Abhängigkeit von der von den Übertragungsbereichen (2) übertragenen Signalladung

während einer Lichtaufnahmeperiode der Verschlußmechansimus geöffnet und die Beziehung $Pr \leq Pt < Ps$ beibehalten wird, (worin Ps, Pt und Pr die Potentiale des Photodetektors (1), der zugehörigen Übertragungs-Gate-Zone (6) bzw. des zugehörigen Übertragungsbereichs (2) bedeuten),

während einer Ausleseperiode der Verschlußmechanismus geschlossen und die Beziehung $Ps \leq Pt < Pr$ beibehalten wird,

und während einer Ladungsübertragungsperiode der Verschlußmechanismus geschlossen wird und die Beziehung $Pt < Ps$ und $Pt < Ps$ und $Pt < Pr$ beibehalten wird,

2. Gerät nach Anspuch 1, bei dem die Halbleiterbildaufnahmeeinrichtung zwischen jeweils zwei aneinandergrenzenden Photodetektoren (1) einen Kanalstopbereich (7) aufweist und diese Kanalstopbereiche (7) und die Übertragungs-Gate-Zonen (6) nicht von der Lichtabschirmungsschicht bedeckt sind.

## Revendications

1. Appareil de prise de vues du type état solide comprenant un dispositif de prise de vues du type état solide qui est du type à transfert d'interlignage, possédant des photodétecteurs (1) servant à produire une charge de signal en réponse à la lumière qu'ils reçoivent et à emmagasiner la charge de signal ainsi produite, des parties de transfert (2) servant à transférer la charge de signal lue dans les photodétecteurs (1), et des zones de porte de transfert (6) placées entre les photodétecteurs (1) et les parties de transfert (2) afin de lire la charge de signal dans les photodétecteurs (1) et la fournir aux parties de transfert correspondantes (2), et étant formé de façon que les photodétecteurs (1) et les parties de transfert (2) ne soivent pas recouverts par une couche (11) de protection contre la lumière, et un mécanisme obturateur associé au dispositif de prise de vues du type état solide, où le mécanisme obturateur est amené à s'ouvrir et la relation $pr \leq Pt < Ps$, Ps, Pt et Pr étant respectivement les potentiels du photodétecteur (1), de la zone de porte de transfert (6) correspondante et de la partie de transfert (2) correspondante, est maintenue pendant période de réception de lumière, le mécanisme obturateur se ferme et la relation $Ps \leq Pt < Pr$ est maintenue pendant une péride de lecture, et le mécanisme obturateur se ferme et la relation $Pt < Ps$ et $Pt < Pr$ est maintenue pendant une période de transfert de charge, de maière qu'il soit produit un signal de sortie de prise de vues en réponse à la charge de signal transférée par les parties de transfert (2).

2. Appareil selon la revendication 1, où ledit dispositif possède en outre une zone d'arrêt de canal (7) entre chaque paire de photodétecteurs adjacents (1), et lesdites zones d'arrêt de canal (7) et lesdites zones de porte de transfert (6) ne sont pas revêtues par la couche de protection contre la lumière (11).

FIG. 1

FIG. 2

0 103 023

FIG. 3

FIG. 4A

FIG. 4B

FIG. 4C

2